# EUROPEAN PATENT APPLICATION

(11) **EP 0 813 302 A1**
(43) Date of publication of application: **17.12.1997**
(21) Application number: 97109198.8
(22) Date of filing: 06.06.1997
(51) Int. Cl.: H03J 1/00

(54) **Broadcasting signal receiver**

(30) Priority: 10.06.1996 JP 146931/96
(71) Applicant: NEC CORPORATION, Tokyo (JP)
(72) Inventor: Kaku, Tomoya, Minato-ku, Tokyo (JP)
(74) Representative: Betten & Resch

(57) **Abstract**

A radio broadcasting signal and a television broadcasting signal in reception is certainly retrieved in the next service area reached. A listener or viewer sets a listening or viewing information of a desired broadcasting content (genre) through an input portion. Together with the listening or viewing information, a current position information is output to position detecting means to a retrieving portion. The retrieving portion retrieves a storage medium for optimal information of broadcasting medium and frequency on the basis of the position information and the listening or viewing information. The retrieving portion outputs the retrieving result information to the channel selecting portion. The channel selecting portion sets the frequency for receiving the broadcasting medium with respect to the broadcasting signal receiver on the basis of the retrieving result information for automatic receiving. When the receiver travels away from the current service area and enters into the next service area, the broadcasting station in the next service area broadcasting the same genre of broadcasting content among the receivable stations, can be automatically tuned to continue reception.

## Description

### BACKGROUND OF THE INVENTION

### Field of the Invention

The present invention relates to a broadcasting signal receiver for receiving FM (frequency modulation) wave, AM (amplitude modulation) wave or television (TV) broadcasting signal with automatically tuning on a desired channel at each moving position.

### Description of the Related Art

As is well known, reception frequency band of a radio broadcasting signal of FM wave and AM wave and channel number of TV broadcasting signal are differentiated at respective broadcasting area. Therefore, when the broadcasting signal is received by a radio receiver set or a TV receiver set mounted on an automotive vehicle, it becomes necessary to note the frequency band of the radio broadcasting signal or channel number of the TV broadcasting signal in the instantaneous traveling position.

There has been known a receiver system facilitating tuning on desired radio broadcasting channel or TV channel at various traveling position. Such receiver system typically utilizes GPS (Global Positioning System), in which the instantaneous traveling position (latitude and longitude) is detected by receiving radio signals transmitted from a plurality of GPS satellites, and automatic tuning is performed by automatically retrieving preliminarily stored broadcasting signal band of the radio broadcasting channel or channel number of the TV broadcasting signal in the detected instantaneously traveling area.

Namely, in this receiver system, the receivable frequency bands of radio broadcasting signals and channel numbers of TV broadcasting signals at respective areas (service areas) are preliminarily stored in a storage medium, such as a CD-ROM. The receivable radio broadcasting stations and TV broadcasting stations at the instantaneous traveling position are retrieved from a map information stored in the CD-ROM or the like on the basis of the position information obtained from GPS. The result of retrieval is displayed on a display screen for noticing to listener or viewer. Also, the radio receiver set or the TV receiver set is automatically tuned to the retrieved radio broadcasting station or the TV broadcasting station.

Such receiver systems have been disclosed in Japanese Unexamined Patent Publication (Kokai) No. Heisei 4-167827, Japanese Unexamined Patent Publication No. Heisei 4-311107, Japanese Unexamined Patent Publication No. Heisei 5-83648 and Japanese Unexamined Patent Publication No. Heisei 6-152332, for example.

In a radio receiver disclosed in Japanese Unexamined Patent Publication No. Heisei 4-167827, detecting means for detecting the current position, storage means for storing locations of respective transmission antennas of respective broadcasting stations and names of the broadcasting stations, and so forth, are provided. Then, the name of the broadcasting station the nearest to the current position is displayed on the display screen to give a notice to the listener.

Therefore, the listener may know the nearest broadcasting station from the current position even when the listener does not know the frequency bands of the broadcasting stations in each service areas.

A broadcasting signal tuning device disclosed in Japanese Unexamined Patent Publication No. Heisei 4-311107 is designed for automatically setting the radio receiver set or the TV receiver set at an optimum tuning condition per instantaneously traveling area. By this, even if the vehicle travels out of the service area while receiving the radio broadcasting program or the TV broadcasting program, it becomes possible to automatically tune on the radio broadcasting station or on the TV broadcasting station of the optimal receiving condition, e.g. the maximum receiving electric field strength, or of the same broadcasting content in the new service area.

A mobile TV receiver set disclosed in Japanese Unexamined Patent Publication No. 5-83648, receivable channels and reception level (receiving electric field strength) at the current position is displayed. Thus, the viewer can recognize the optimal channel to receive.

As a result, even upon moving out of the current service area during reception of the TV broadcasting signal, the new TV broadcasting channel in the new service area broadcasting the same content can be recognized.

A receiver and Receiving method disclosed in such Japanese Unexamined Patent Publications is designed to enable automatic tuning of at the position of the viewer in a broadcasting network relay broadcasting the same program from a key station.

As a result, it becomes possible to tune on the desired broadcasting station even when the frequency bands, channel numbers and so forth of the broadcasting systems in each areas are not known.

Even in such prior art, when the radio broadcasting signal of FM wave or AM wave or so forth or the TV broadcasting signal is received during travel, the radio broadcasting signal or the TV broadcasting signal in the service area can be appropriately receive even when the broadcasting frequency bands and the channel numbers of the broadcasting station in the instantaneous service area are not known.

However, the foregoing prior art cannot be adapted to receive a plurality of kinds of broadcasting content. In some broadcasting stations, broadcasting of specific content (or specific genres of contents), such as news, music and so forth have been performed. Among these specific genres, there are more specifically separated specific kinds of broadcasting.

For example, there are some broadcasting stations dedicated for broadcasting of Rock music in the music genre, economic news in the news genre and so forth. Also, there is a broadcasting station which broadcast specific information at specific timing, such as traffic information at specific timing, or the like.

Upon receiving such specific content of broadcasting signal, the listener or viewer has to set the reception band or reception channel. In such case, if the desired program is broadcasted in only limited timing, such as the traffic information, the program can end during tuning. In other words, the conventional receiver systems discussed above cannot certainly receive various broadcasting signals at the instantaneous traveling positions.

### SUMMARY OF THE INVENTION

The present invention has been worked out for solving the problems in the prior art, as set forth above. Therefore, it is an object of the present invention to provide a broadcasting signal receiver which assures reception of desired specific content (genre) of radio broadcasting signal of FM wave or AM wave or of TV broadcasting signal even when frequency band or the channel number is not known.

Another object of the invention is to provide a broadcasting signal receiver, which can certainly retrieve the broadcasting frequency band or the broadcasting channel number in a next service area upon moving out of one service area and thus permit continuous reception of the same program.

A further object of the present invention is to provide a broadcasting signal receiver which can certainly receive a specific broadcasted program broadcasted at only limited timing, such as traffic information.

According to the first aspect of the invention, a broadcasting signal receiver comprises:
current position detecting means for detecting a current position of the receiver;
input means for inputting a request for desired content of a broadcasting program to receive;
a storage medium for preliminarily storing broadcasting content information including names of broadcasting station, position, broadcasting system and frequency;
retrieving means for retrieving a frequency information of the desired broadcasting station corresponding to the current position information detected by the current position detecting means and broadcasting content information designated by the input means, from the storage medium for tuning; and
receiving means for automatically tuning the broadcasting station on the basis of the result of retrieval by the retrieving means and receiving the broadcasting signal therefrom.

According to the second aspect of the invention, a broadcasting signal receiver comprises:
current position detecting means for detecting a current position of the receiver;
input means for inputting a request for desired content of a broadcasting program to receive;
multiplexed broadcasting signal receiver receiving a multiplexed broadcasting signal, outputting adjacent station information together with a program information, automatically tuning a frequency on the basis of tuning information for receiving;
a storage medium storing the adjacent station information from the multiplexed broadcasting signal receiver; and
retrieving means for retrieving a frequency information of the adjacent broadcasting station for receiving next to the currently receiving broadcasting station corresponding to the current position information detected by the current position detecting means and broadcasting content information designated by the input means, for automatic tuning of the adjacent station on the basis of the result of retrieval for receiving.

The storage medium may store at least broadcasting content and broadcasting start timing, clock means for measuring a current time is provided for automatically receiving the broadcasting content retrieved by the retrieving means at the broadcasting start timing detected by the clock means.

When a plurality of broadcasting stations are retrieved by the retrieving means, the broadcasting station broadcasting the broadcasting content at the earliest timing may be taken as the result of retrieval.

The broadcasting content designated by the input means may be a genre type information, such as news, music, drama, traffic information, horse race.

The broadcasting system includes at least two of television broadcasting, FM wave broadcasting and AM broadcasting, and the receiving means selects and receives desired system among these systems.

The current position detecting means may detect the current position on the basis of the position information obtained from GPS.

The adjacent station information may include the broadcasting start time information started the broadcasting of the adjacent station, and effect automatic receiving at the broadcasting start time.

### BRIEF DESCRIPTION OF THE DRAWINGS

The present invention will be understood more fully from the detailed description given hereinafter and from the accompanying drawings of the preferred embodiment of the present invention, which, however, should not be taken to be limitative to be present invention, but are for explanation and understanding only.

In the drawings:
Fig. 1 is a block diagram showing a construction of the first embodiment of a broadcasting signal receiver according to the present invention;
Fig. 2 is a table showing a content of information of broadcasting stored in a storage medium employed in the first embodiment of the broadcasting signal receiver of Fig. 1;
Fig. 3 is a block diagram showing a construction of the second embodiment of a broadcasting signal receiver according to the present invention;
Fig. 4 is a table showing a content of information of broadcasting stored in a storage medium employed in the second embodiment of the broadcasting signal receiver of Fig. 3;
Fig. 5 is a block diagram showing a construction of the third embodiment of a broadcasting signal receiver according to the present invention;
Fig. 6 is a block diagram showing a construction of the fourth embodiment of a broadcasting signal receiver according to the present invention; and
Fig. 7 is a table showing a content of information of broadcasting stored in a storage medium employed in the fourth embodiment of the broadcasting signal receiver of Fig. 6.

### DESCRIPTION OF THE PREFERRED EMBODIMENT

The present invention will be discussed hereinafter in detail in terms of the preferred embodiment of the present invention with reference to the accompanying drawings. In the following description, numerous specific details are set forth in order to provide a thorough understanding of the present invention. It will be obvious, however, to those skilled in the art that the present invention may be practiced without these specific details. In other instance, well-known structures are not shown in detail in order to avoid unnecessary obscure the present invention.

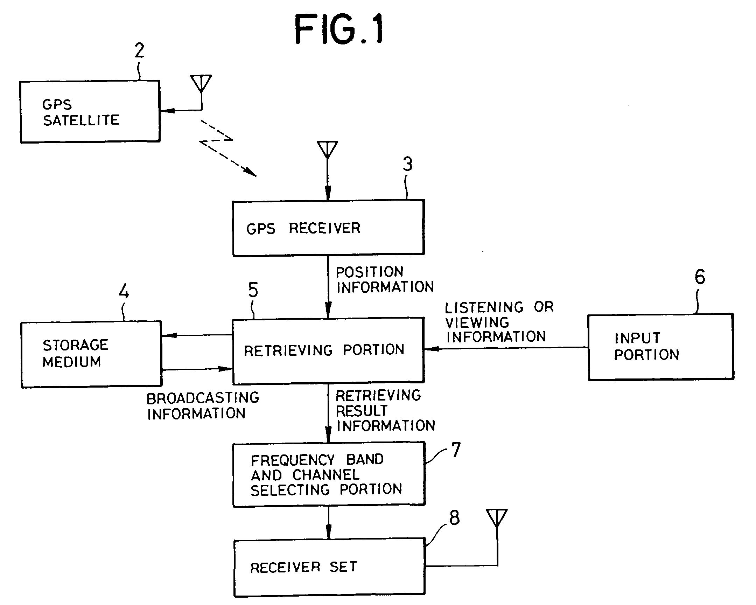

Fig. 1 is a block diagram showing a construction of the first embodiment of a broadcasting signal receiver according to the present invention.

A broadcasting signal receiver of Fig. 1 includes a GPS receiver device 3 receiving radio waves transmitted from more than or equal to three satellites and outputs two dimensional (latitude and longitude) position information of a current position, a storage medium 4 preliminarily storing frequency bands and TV channel numbers of FM wave or AM wave radio broadcasting stations and TV stations receivable at the currently traveling area (service area).

Also, the shown embodiment of the broadcasting signal receiver includes a retrieving portion 5 for retrieving frequency band or the channel number of the desired broadcasting station, and an input portion 6 inputting a designation of a desired broadcasting content and outputting a listening or viewing information. The broadcasting signal receiver further includes a frequency band or channel selecting portion 7 for automatically tuning the frequency band of the desired radio broadcasting station or setting the channel number of the desired TV broadcasting station based on the information of the result of retrieval obtained through retrieval by the retrieving portion 5, and a receiver set 8 for receiving the radio broadcasting signal or the TV broadcasting signal of the radio broadcasting station or the TV broadcasting station selected by the frequency band or channel selecting portion 7.

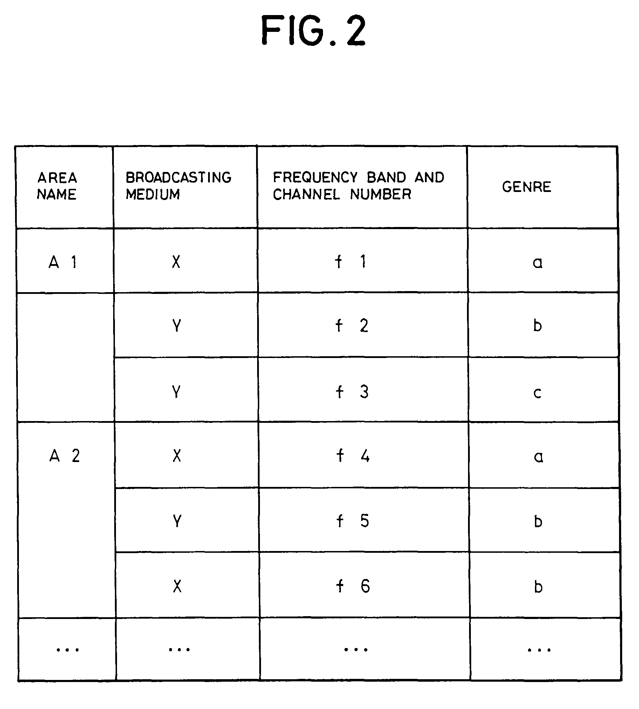

Fig. 2 is a table showing a content of information of broadcasting stored in a storage medium employed in the first embodiment of the broadcasting signal receiver of Fig. 1.
In the storage medium 4 shown in Fig. 2, "area name A1, A2...." corresponding to position information output from the GPS receiver device 3 and "broadcasting medium X, Y" indicative of broadcasting type receivable in the relevant area, are stored. Also, the storage medium 4 preliminarily stores "frequency band and channel number f1, f2, f3, f4, f5, f6 ...." and "broadcasting contents (genre) a, b, c" are stored.

Next, operation of the foregoing first embodiment of the broadcasting signal receiver will be discussed.

In Figs. 1 and 2, the listener or viewer inputs the broadcasting content a, b or c as listening or viewing information by operating the input portion 6. Here, it is assumed that genre a is selected and thus a request for the genre a is input through the input portion 6. The GPS receiver device 3 receives the radio waves from the satellites 2 and processes the radio waves according to the per se known GPS technology to derive the two-dimensional information (position information) of the current traveling position to the retrieving portion 5. Here, the current position is assumed to be within the area A2.

The retrieving portion 5 retrieves the broadcasting station broadcasting a program of genre a in the area A2 on the basis of the position information, listening or viewing information and the information of broadcasting stored in the storage medium 4. As a result, in the shown example, a broadcasting medium X and the frequency band f4 is assumed to be matched with the request of the listener of the viewer. The result is output to the frequency band and channel selecting portion 7 as the information of the result of retrieval. The frequency band and channel selecting portion 7 performs setting for the frequency band f4 for receiving broadcasting of the medium X for the receiver set 8 on the basis of the retrieval result indicative information. By this setting, the receiver set 8 can be automatically tuned on the broadcasting station of the frequency band f4.

Next, discussion will be given for the case where the shown embodiment of the broadcasting signal receiver travels away from the service area of the current position.

The GPS receiver 3 constantly detects current traveling position of the shown embodiment of the broadcasting signal receiver. For example, when the current position of the broadcasting signal receiver travels from the area A2 to the area A1 in Fig. 2, the retrieving portion 5 again performs retrieval of the frequency band and channel number of the broadcasting station of the program in genre a in the new service area A1 from the storage medium 4 on the basis of the position information and the listening or viewing information.

As a result, in case of the broadcasting medium X and the frequency f1 is matched with the requested condition, the frequency band and channel selecting portion 7 modifies setting of the receiver set 8 so as to receive the broadcasting signal of the broadcasting station of the broadcasting medium X and the frequency f1 from the broadcasting medium X and the frequency f4. Thus, the receiver set 8 is automatically tuned for receiving the broadcasting station of the broadcasting medium X and frequency f1.

As set forth above, in the first embodiment set forth above, the receiver set 8 is tuned on the broadcasting station of the desired genre among receivable broadcasting station at the current traveling position. On the other hand, even when the shown embodiment of the broadcasting signal receiver travels out of the current service area to enter into the new service area, the broadcasting station broadcasting the desired genre of program in the new service area can be automatically tuned to permit continuous reception of the desired genre of program.

Next, the second embodiment of the broadcasting signal receiver according to the present invention will be discussed.

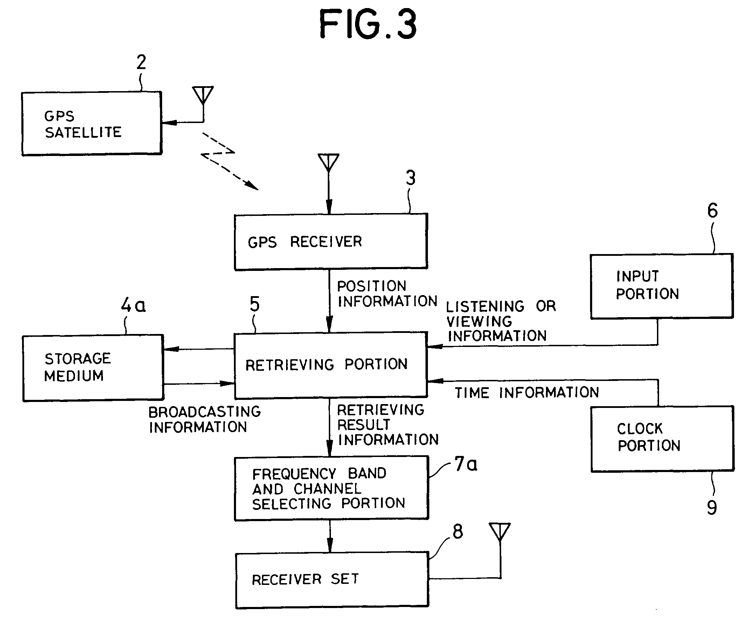

Fig. 3 is a block diagram showing a construction of the second embodiment of a broadcasting signal receiver according to the present invention.

The second embodiment of the broadcasting signal receiver shown in Fig. 3 additionally includes a clock portion 9 measuring a current time and outputs a time information to the retrieving portion 5. Also, the shown embodiment of the broadcasting signal receiver includes a storage medium 4a which preliminarily stores a broadcasting time in addition to the broadcasting information, such as the frequency bands and channel numbers of the radio broadcasting signals and the TV broadcasting signals, the broadcasting content and so forth.

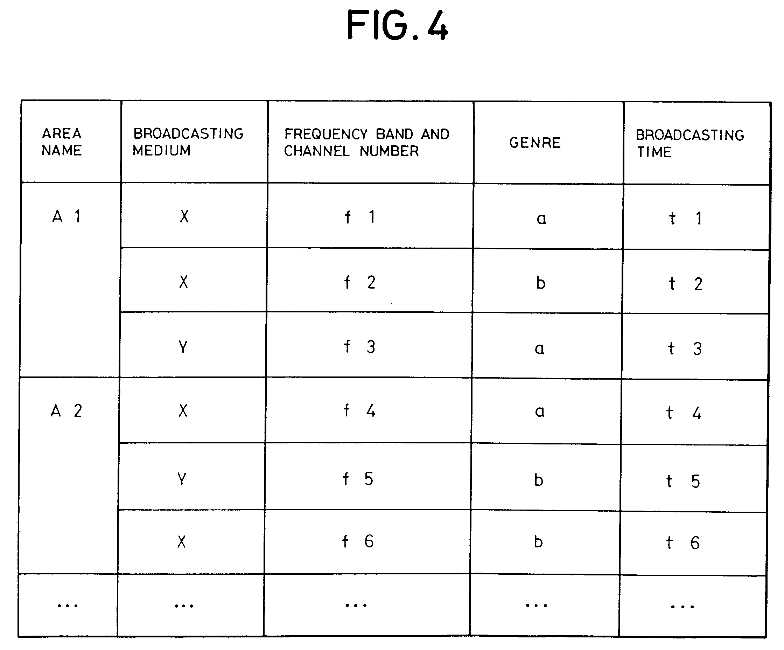

Fig. 4 is a table showing a content of information of broadcasting stored in a storage medium 4a employed in the second embodiment of the broadcasting signal receiver of Fig. 3. On the storage medium 4a shown in Fig. 4, "area name A1, A2...", "broadcasting medium X, Y", "frequency band and channel number f1 ∼ f6", "broadcasting content "genre" a ∼ c" are stored similarly to the first embodiment shown in Fig. 2. In addition, "broadcasting time t1, t2, t3, t4, t5, t6 ..." with respect to the "broadcasting content "genre" a ∼ c" is also stored in the storage medium 4a.

Next, the operation of the second embodiment of the broadcasting signal receiver will be discussed.

In Fig. 4, the listener or viewer inputs listening or viewing information of the broadcasting content "genre" a, desired to receive, by operating the input portion 6. On the other hand, it is assumed that the current position of the shown embodiment of the broadcasting signal receiver detected by the GPS receiver 3 is the area A2. Then, the time information indicative of the current time from the clock portion 9 input to the retrieving portion 5 is time tx, for example.

In the retrieving portion 5, the broadcasting station of the broadcasting content (genre) a in the area A2 is retrieved on the basis of the position information, the listening and viewing information, the broadcasting information stored in the storage medium 4a. As a result, the broadcasting medium X and the frequency f4 are retrieved, and the time information, e.g. time tx, indicative of the current time is input to the retrieving portion 5 from the clock portion 9.

As a result, when the current time tx reaches a broadcasting time t4, the clock portion 9 causes interruption in the retrieving portion 5. Then, the retrieving portion 5 outputs the retrieval result indicative information indicative of the broadcasting information X and the frequency f4, to the frequency band and channel selecting portion 7a. On the basis of the input retrieval result indicative information, the frequency band and the channel selecting portion 7a sets the frequency f4 to the receiver set 8 for receiving the broadcasting medium X. Then, the receiver set 8 performs automatic tuning for reception.

In the foregoing second embodiment, the receiver set 8 is automatically tuned to the broadcasting station broadcasting the desired genre at the broadcasting time. On the other hand, even when the broadcasting signal receiver travels away from the service area, the broadcasting station broadcasting the same genre of program in the next service area can be automatically tuned to continue reception.

It should be noted when the a plurality of broadcasting stations are retrieved as a result of retrieval on the basis of the position information, the listening and viewing information and the broadcasting information stored on the storage medium 4a, the current time information from the clock portion 9 and the respective broadcasting time information in the retrieval result are compared to output the broadcasting station having the closest time information as the retrieval result information. As a result, the broadcasting program desired by the listener or the viewer is automatically received at the broadcasting time.

Next, the third embodiment of the broadcasting signal receiver will be discussed.

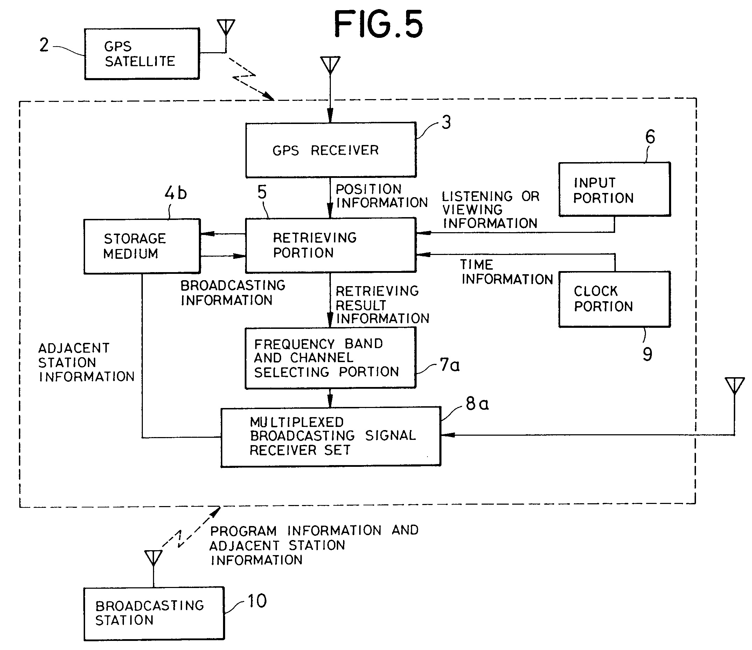

Fig. 5 is a block diagram showing a construction of the third embodiment of a broadcasting signal receiver for receiving a multiplexed broadcasting signal according to the present invention. In the third embodiment of the broadcasting signal receiver shown in Fig. 5, the broadcasting station 10 broadcasts the program together with adjacent station information in multiplexed manner. The broadcasting signal receiver has the similar construction to the second embodiment of Fig. 3. However, the shown embodiment of the broadcasting signal receiver includes a storage medium 4b storing adjacent station information indicative of the broadcasting station in the adjacent service area broadcasting the same genre, and a multiplexd broadcasting signal receiver 8a receiving multiplexed broadcasting to output the adjacent broadcasting station information to the storage medium 4b. It should be noted that the storage medium 4b employed in the shown embodiment is a writeable medium, such as CD-R (CD recordable), MO (magneto-optical disk) or RAM (randum access memory).

Next, operation of the third embodiment of the broadcasting signal receiver will be discussed.

In Fig. 5, the listener or viewer operates the input portion 6 to input listening or viewing information of genre a, for example desired to receive. On the other hand, from the GPS receiver 3, the position information is input. Here, it is assumed that the position information input from the GPS receiver 3 is the area A2. In addition, from the clock portion 9, the time information indicative of the current time, e.g. time tx, is input to the retrieving portion 5. At the same time, the multiplexing broadcasting signal receiver 8a receives the multiplexed program information and the adjacent station information from the broadcasting station 10, and the adjacent station information is output to the storage medium 4b. Then, the adjacent station information is stored in the storage medium 4b.

The retrieving portion 5 retrieves the optimal frequency range or the channel number of the broadcasting station broadcasting the same genre in the next service area from the preceding service area, the broadcasting information in the storage medium 4b, namely the position information, the listening and viewing information and adjacent station information. The retrieving portion 5 outputs the retrieval result information to the frequency band and channel selecting portion 7a. On the basis of the retrieval result information, the frequency range and channel selecting portion 7a outputs the frequency information for receiving the relevant broadcasting station to the multiplexing broadcasting signal receiver set 8a to perform automatic tuning by the multiplexing broadcasting signal receiver set 8a for reception.

On the other hand, when the multiplexed broadcasted signal contains the most recent broadcasting time information together with the adjacent station information, and to store these information in the storage medium 4b, it becomes possible to receiver the broadcasted program of the adjacent station adapted to the modified time even when the broadcasting time in the adjacent broadcasting station is changed.

As set forth, in the third embodiment, the multiplexed program information and the adjacent station information is received, and on the basis of the adjacent station information, the broadcasting station broadcasting the same genre of program, for example, in the next service area can be certainly retrieved and received even when the broadcasting signal receiver travels out of the current service area.

Next, the fourth embodiment of the broadcasting signal receiver will be discussed.

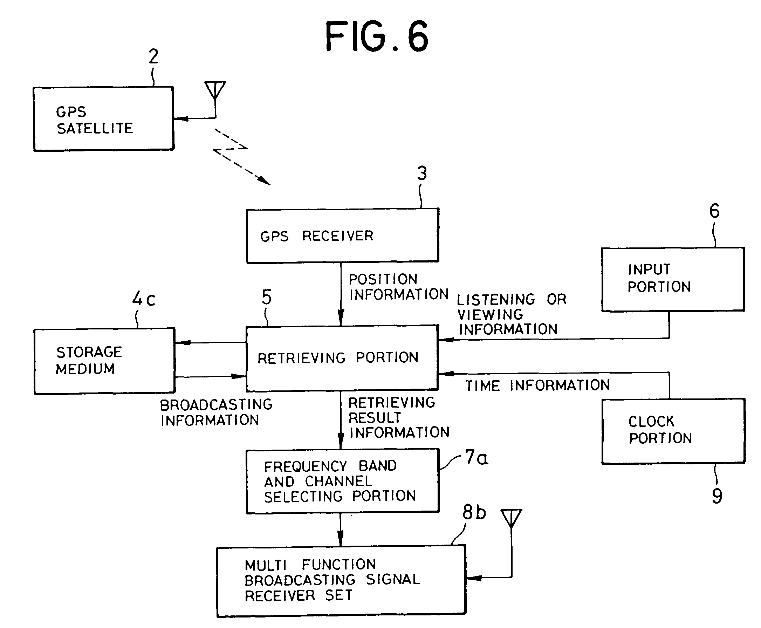

Fig. 6 is a block diagram showing a construction of the fourth embodiment of a broadcasting signal receiver for selectively receiving the AM wave broadcasting signal, the FM wave broadcasting signal and the TV broadcasting signal according to the present invention.

The broadcasting signal receiver shown in Fig. 6 has substantially the same construction as the second embodiment shown in Fig. 3. The broadcasting signal receiver includes a storage medium 4c storing broadcasting information of the AM wave broadcasting signal, the FM wave broadcasting signal and the TV broadcasting signal, and a multi-function broadcasting signal receiver 8b selectively receiving the AM wave broadcasting signal, the FM wave broadcasting signal and the TV broadcasting signal.

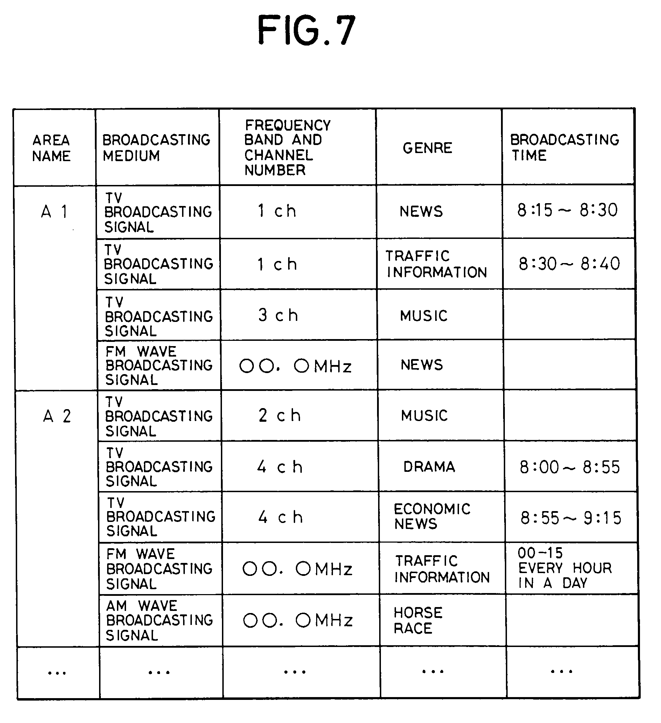

Fig. 7 is a table showing a content of information of broadcasting stored in the storage medium 4c employed in the fourth embodiment of the broadcasting signal receiver of Fig. 6.

The content of the broadcasted information shown in Fig. 7 is basically the same as the first embodiment shown in Fig. 2. "Broadcasting medium of TV broadcasting signal, TV broadcasting signal, TV broadcasting signal and FM wave broadcasting signal" corresponding to "area A1", and respective "frequency band and channel number of 1ch, 1ch, 3ch and OO.O MHz" are stored. Furthermore, respective of the "broadcasting content (genre) of news, traffic information, music, news" are stored. Subsequently, "broadcasting time 8:15 ∼ 8:30" and next 1ch of traffic information of "broadcasting time of 8:30 ∼ 8:41" are stored.

Similarly, "broadcasting medium of TV broadcasting signal, TV broadcasting signal, TV broadcasting signal, FM wave broadcasting signal and AM wave broadcasting signal" corresponding to "area A2", and respective "frequency band and channel number of 2ch, 4ch, 4ch, OO.O MHz and OO.O KHz" are stored. Furthermore, respective of the "broadcasting content (genre) of music, drama, economic news, traffic information and horse race" are stored. Subsequently, 4ch of drama of "broadcasting time 8:00 ∼ 8:55", next 4ch of economic news of "broadcasting time of 8:55 ∼ 9:15" and FM wave broadcasting signal of traffic information of "broadcasting time every 00 ∼ 15" are stored.

Next, operation of the fourth embodiment will be discussed.

In Figs. 6 and 7, the desired genre (traffic information), for example, is input as the listening and viewing information, is input by the listener or viewer through the input portion 6. Also, the position information is input from the GPS receiver 3. It is assumed that the position information indicate "area A2". Then, from the clock portion 9, the time information indicative of the current time, e.g. tx, is input to the retrieving portion 5.

In the retrieving portion 5, the storage medium 4c is retrieved for obtaining the frequency or the channel number of the optical broadcasting station on the basis of the position information and the listening or viewing information. As a result, it can be found that the broadcasting station in the area A2 broadcasts the traffic information at a frequency of oo.o MHz, and the FM wave broadcasting signal per every 00 ∼ 15 of every hour in the day. The retrieval result information is output to the frequency band and channel selecting portion 7a. The frequency band and channel selecting portion 7a then sets the multi-function broadcasting signal receiver 8b to automatically receive the frequency OO.O MHz at respective 00 to 15 of every hour in the day.

As set forth above, in the fourth embodiment, the broadcasting program, such as the genre of the traffic information, set by the listener or the viewer through the input portion 6 can be automatically tuned on the broadcasting station among the stations receivable in the current service area and received.

As can be clear from the discussion given hereabove, according to the present invention, the frequency or channel number information of the objective station of tuning can be obtained by retrieving the storage medium on the basis of the current position information and the input broadcasting content information. Also, automatic tuning of the broadcasting station on the basis of the result of retrieval can be done for receiving the desired program. Therefore, even when specific content (genre) of the desired FM wave or AM wave of the radio broadcasting signal or the TV broadcasting signal is not known, the broadcasting of the specific content can be certainly received.

On the other hand, by receiving the multiplexed broadcasting signal, on the basis of the frequency information of the adjacent station obtained the broadcasting signal, since the station in the adjacent service area is received by automatic tuning from the current service area, even if the broadcasting signal receiver travels away from the current service area and enters into the adjacent service area, the broadcasting station of the next service area broadcasting the same content can be certainly retrieved and tuned to continue reception.

On the other hand, by storing the broadcasting start time together with the frequency information on the storage medium, the automatic tuning on the station broadcasting the desired program timely. Therefore, the specific program broadcasted at specific timing, such as traffic information, can be certainly received by automatic tuning.

Furthermore, even when a plurality of stations are retrieved through retrieval, the broadcasting station to start the desired program at the earliest timing can be retrieved to receive the broadcasted signal. Therefore, the specific content of broadcasting signal, such as the traffic information, broadcasted at the earliest timing can be certainly received.

Although the invention has been illustrated and described with respect to exemplary embodiment thereof, it should be understood by those skilled in the art that the foregoing and various other changes, omissions and additions may be made therein and thereto, without departing from the spirit and scope of the present invention. Therefore, the present invention should not be understood as limited to the specific embodiment set out above but to include all possible embodiments which can be embodied within a scope encompassed and equivalents thereof with respect to the feature set out in the appended claims.

## Claims

1. A broadcasting signal receiver comprising:
current position detecting means for detecting a current position of the receiver;
input means for inputting a request for desired content of a broadcasting program to receive;
a storage medium for preliminarily storing broadcasting content information including names of broadcasting station, position, broadcasting system and frequency;
retrieving means for retrieving a frequency information of the desired broadcasting station corresponding to the current position information detected by said current position detecting means and broadcasting content information designated by said input means, from said storage medium for tuning; and
receiving means for automatically tuning the broadcasting station on the basis of the result of retrieval by said retrieving means and receiving the broadcasting signal therefrom.

2. A broadcasting signal receiver as set forth in claim 1, wherein said storage medium stores at least broadcasting content and broadcasting start timing, clock means for measuring a current time is provided for automatically receiving the broadcasting content retrieved by said retrieving means at the broadcasting start timing detected by said clock means.

3. A broadcasting signal receiver as set forth in claim 1, wherein, when a plurality of broadcasting stations are retrieved by said retrieving means, the broadcasting station broadcasting the broadcasting content at the earliest timing is taken as the result of retrieval.

4. A broadcasting signal receiver as set forth in claim 1, wherein the broadcasting content designated by said input means is a genre type information, such as news, music, drama, traffic information, horse race.

5. A broadcasting signal receiver as set forth in claim 1, wherein said broadcasting system includes at least two of television broadcasting, FM wave broadcasting and AM broadcasting, and said receiving means selects and receives desired system among these systems.

6. A broadcasting signal receiver as set forth in claim 1, wherein said current position detecting means detects the current position on the basis of the position information obtained from GPS.

7. A broadcasting signal receiver comprising:
current position detecting means for detecting a current position of the receiver;
input means for inputting a request for desired content of a broadcasting program to receive;
multiplexed broadcasting signal receiver receiving a multiplexed broadcasting signal, outputting adjacent station information together with a program information, automatically tuning a frequency on the basis of tuning information for receiving;
a storage medium storing said adjacent station information from said multiplexed broadcasting signal receiver; and
retrieving means for retrieving a frequency information of the adjacent broadcasting station for receiving next to the currently receiving broadcasting station corresponding to the current position information detected by said current position detecting means and broadcasting content information designated by said input means, for automatic tuning of the adjacent station on the basis of the result of retrieval for receiving.

8. A broadcasting signal receiver as set forth in claim 7, wherein said storage medium stores at least broadcasting content and broadcasting start timing, clock means for measuring a current time is provided for automatically receiving the broadcasting content retrieved by said retrieving means at the broadcasting start timing detected by said clock means.

9. A broadcasting signal receiver as set forth in claim 7, wherein, when a plurality of broadcasting stations are retrieved by said retrieving means, the broadcasting station broadcasting the broadcasting content at the earliest timing is taken as the result of retrieval.

10. A broadcasting signal receiver as set forth in claim 7, wherein the broadcasting content designated by said input means is a genre type information, such as news, music, drama, traffic information, horse race.

11. A broadcasting signal receiver as set forth in claim 7, wherein said broadcasting system includes at least two of television broadcasting, FM wave broadcasting and AM broadcasting, and said receiving means selects and receives desired system among these systems.

12. A broadcasting signal receiver as set forth in claim 7, wherein said current position detecting means detects the current position on the basis of the position information obtained from GPS.

13. A broadcasting signal receiver as set forth in claim 7, wherein said adjacent station information includes the broadcasting start time information started the broadcasting of the adjacent station, and effect automatic receiving at the broadcasting start time.
